# EUROPÄISCHE PATENTSCHRIFT

(11) **EP 0 741 409 B1**
(45) Veröffentlichungstag und Bekanntmachung des Hinweises auf die Patenterteilung: **17.10.2001**
(21) Anmeldenummer: 96810261.6
(22) Anmeldetag: 24.04.1996
(51) Int. Cl.: H01L 23/367, H01L 21/48

(54) **Kühlkörper für Halbleiterbauelemente**
Heat sink for semiconductor devices
Dissipateur de chaleur pour des dispositifs semi-conducteurs

(30) Priorität: 04.05.1995 DE 29507286 U
(43) Veröffentlichungstag der Anmeldung: 06.11.1996
(73) Patentinhaber: Alusuisse Technology & Management AG, 8212 Neuhausen am Rheinfall (CH)
(72) Erfinder: Bock, Uwe, 78224 Singen (DE); Glück, Joachim, 78713 Schramberg-Sulgen (DE)

(56) Entgegenhaltungen:
- DE-A- 2 502 472
- DE-A- 3 518 310
- DE-A- 4 314 663
- US-A- 3 422 777

## Beschreibung

Die Erfindung betrifft einen Kühlkörper für Halbleiterbauelemente od.dgl. Geräte mit in Abstand zueinander an ein Grundprofil aus stranggepreßtem Aluminium oder anderem Leichtmetall angeschlossenen und davon aufragenden Kühlrippen, die jeweils in einer Einsatznut od.dgl. Ausnehmung des Grundprofils festliegen.

Die DE-PS 35 18 310 beschreibt stranggepreßte Vollprofile mit seitlichen Ausformungen als Kühlrippen, die in Einsatznuten der Grundplatte formschlüssig eingesetzt werden. Zudem erwähnt diese Druckschrift sog. Rippenverhältnisse (Verhältnis der Höhe zum lichten Abstand) von mehr als 12 : 1, womit die Grenze der erreichbaren Oberfläche bestimmt ist. Sowohl technische als auch wirtschaftliche Gesichtspunkte erfordern je nach Rippenhöhe eine Mindestrippendicke. Die Fertigung eines Kühlkörpers mit dünnen Rippen bei hoher Rippenzahl geht wegen des größeren Aufwandes zu Lasten der Wirtschaftlichkeit.

Gegenüber der Lehre der DE-PS 35 18 310 stellt eine gattungsgemäßen Kühlkörper mit zwischen zwei -- mit der Grundplatte eine Art Rechteckrinne ergebenden --Flankenwänden verlaufenden Kühlrippen nach der EP-A-0 483 058 der Anmelderin eine Verbesserung dar. Sowohl die Innenflächen der Flankenwände als auch die Außenflächen der Kühlrippen sind mit Riffelungen ausgestattet, die parallel zur Grundplatte verlaufen. Die beiden Rippenwände jeder Kühlrippe sind an einem Ende durch einen in der Einsatznut der Grundplatte festlegbaren Kupplungssockel und am anderen Ende durch einen Quersteg verbunden; ein weiterer Quersteg teilt den Rippenhohlraum etwa in halber Höhe in zwei Kanäle. Mit diesem Kühlkörper sollten sowohl die Wanddicken von Kühlrippen als auch der Herstellungsaufwand für den Kühlkörper vermindert werden.

Ein weiterer Kühlkörper dieser Gattung ist aus DE-A-25 02 472 bekannt.

Im Gegensatz zu Kühlkörpern für Zwangsbelüftung bzw. erzwungene Konvektion lassen Kühlkörper für freie Konvektion Rippen geringer Dicke und relativ großer Höhe zu. Als Strangpreßprofile sind solche Rippen nicht herstellbar. Der Einsatz von normalen Blechen ist nicht möglich, da die hierfür erforderliche geringe Weite der Einsatznuten des Grund- oder Basisprofils strangpreßtechnisch nicht realisiert zu werden vermag.

In Kenntnis dieses Standes der Technik hat sich der Erfinder die Aufgabe gestellt, die Herstellung des gattungsgemäßen Kühlkörpers freier Konvektion zu verbessern.

Zur Lösung dieser Aufgabe führt die Lehre nach dem unabhängigen Anspruch; die Unteransprüche geben günstige Weiterbildungen an.

Erfindungsgemäß sind die Kühlrippen jeweils als Kühlplatten aus einem dünnen Werkstoffstreifen ausgebildet, und ihr Längsschnitt ist zumindest im Bereich ihrer Verbindung mit dem Grundprofil teilweise durch Profilierung erweitert; hierdurch wird die Verbindung mit Einsatznuten preßbarer Dimensionierung ermöglicht.

Bei einer Ausgestaltung des Kühlkörpers ist die Kühlplatte aus einem Blech wellenartig ausgeformt, wobei der die Längsachse querende Abstand zwischen zwei von den Wellenspitzen bestimmten Ebenen der Breite jener Einsatznuten entspricht.

Eine weitere Ausgestaltung zeigt eine Kühlplatte, die längsschnittlich unter Bildung schulterartiger Absätze sägezahnartig profiliert ist.

Dank dieser Maßgaben werden also zwei Lösungswege angeboten, zum einen der Einsatz eines wellenartig ausgeformten Bleches, zum anderen die Verwendung eines sägezahnförmig verformten Bleches, wobei das eingefügte Blech wesentlich länger sein kann als das Grundprofil.

Nach einem weiteren Merkmal der Erfindung verläuft zwischen zwei benachbarten schulterartigen Absätzen eine längsschnittliche Pultfläche, die an der Spitze des einen Absatzes endet. Die andere Seite der Pultfläche kann in ein achsparalleles Flächenstück übergehen.

Im Rahmen der Erfindung liegt es, daß das Grund- oder Basisprofil zwischen jeweils zwei Einsatznuten eine Quereinformung anbietet, die sich einwärts verjüngen kann.

Zudem hat es sich als günstig erwiesen, diese Quereinformung tiefer in das Grundprofil hineinzuführen als die Einsatznut.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in:
- Fig. 1, 4, 8:: teilweise Seitenansichten von Ausführungen eines Kühlkörpers aus einem Grundprofil und daran festgelegten Kühlplatten;
- Fig. 2, 5:: zwei Frontansichten zu den in Fig. 1, 4 dargestellten Kühlkörpern (Fig. 5 teilweise geschnitten gemäß Linie V-V der Fig. 4);
- Fig. 3:: einen vergrößerten Ausschnitt aus Fig 1 nach deren Feld III;
- Fig. 6, 7:: vergrößerte Querschnitte der Fig. 5 nach deren Schnittlinien VI-VI bzw. VII-VII;
- Fig. 9:: einen Abschnitt aus einer Frontansicht zu Fig. 8;
- Fig. 10:: den Schnitt durch Fig. 9 nach deren Linie X-X.

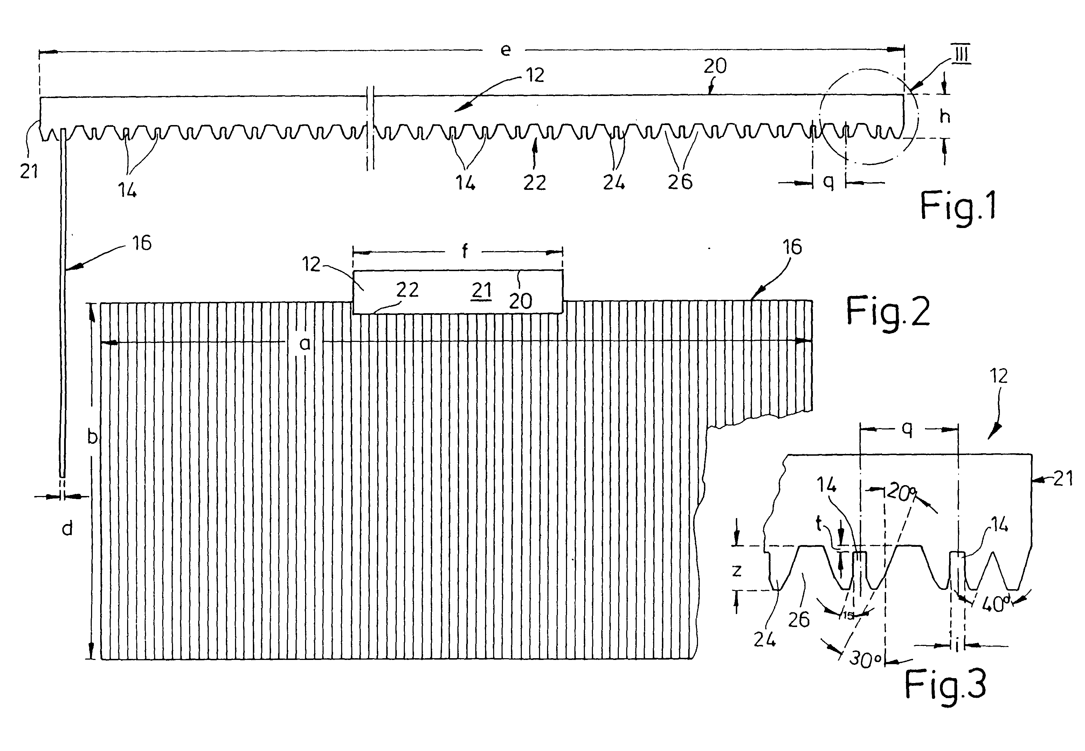

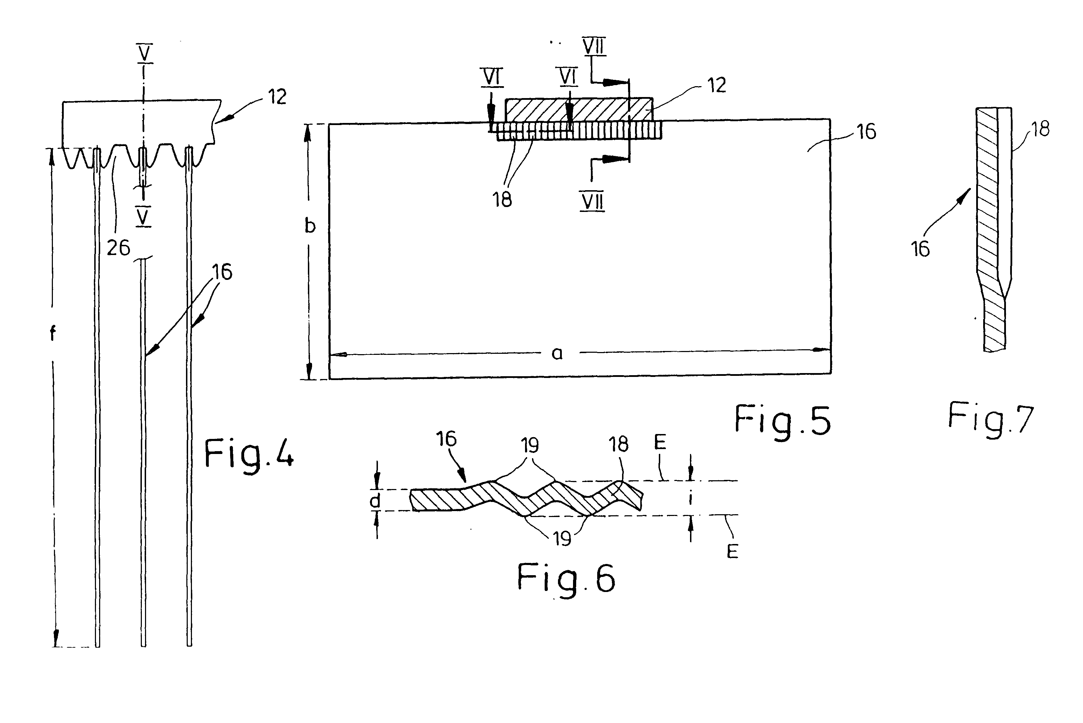

Ein Kühlkörper 10 besteht gemäß Fig. 1, 2 aus einem Grund- oder Basisprofil 12 und von diesem in Einsatznuten 14 klemmend gehaltenen Kühlplatten 16 der Länge a von 240 mm und der Höhe b von 120 mm. Das dafür eingesetzte Blech der Dicke d von 1,4 mm ist in Richtung seiner Längsachse A (Fig. 6) gewellt; dies lassen vor allem die Fig. 6, 7 anhand von Wellen 18 erkennen. Deren Wellenspitzen 19 bestimmen an beiden Seiten jener Längsachse A jeweils eine dazu parallele Ebene E. Der Abstand der Ebenen E voneinander entspricht der Breite i der Einsatznuten 14.

Das Grund- oder Basisprofil 12 einer Länge e von 583 mm, einer Breite f von 70 mm und einer Höhe h von 15 mm ist beispielsweise aus AlMgSi O.5 F 22 stranggepreßt.

Sowohl die Oberfläche 20 als auch die Stirnflächen 21 des Grund- oder Basisprofils 12 sind eben, wohingegen die --jene quer zu seiner Längserstreckung verlaufenden Einsatznuten 14 aufweisende -- Unterfläche 22 gemäß Fig. 3 zwischen -- benachbarte Einsatznuten 14 stetiger Breite i von etwa 1,6 mm flankierenden -- Rippen 24 Quereinformungen 26 sich einwärts verjüngender Weite n anbietet. Der Abstand q zwischen den Einsatznuten 14 mißt 11 mm, der Höhenabstand t zwischen deren Tiefstem und dem Tiefsten der Quereinformung 26 hier 0,7 mm; die Tiefe z der im Verhältnis zur Einsatznut 14 tieferen Quereinformung 26 beträgt 5 mm.

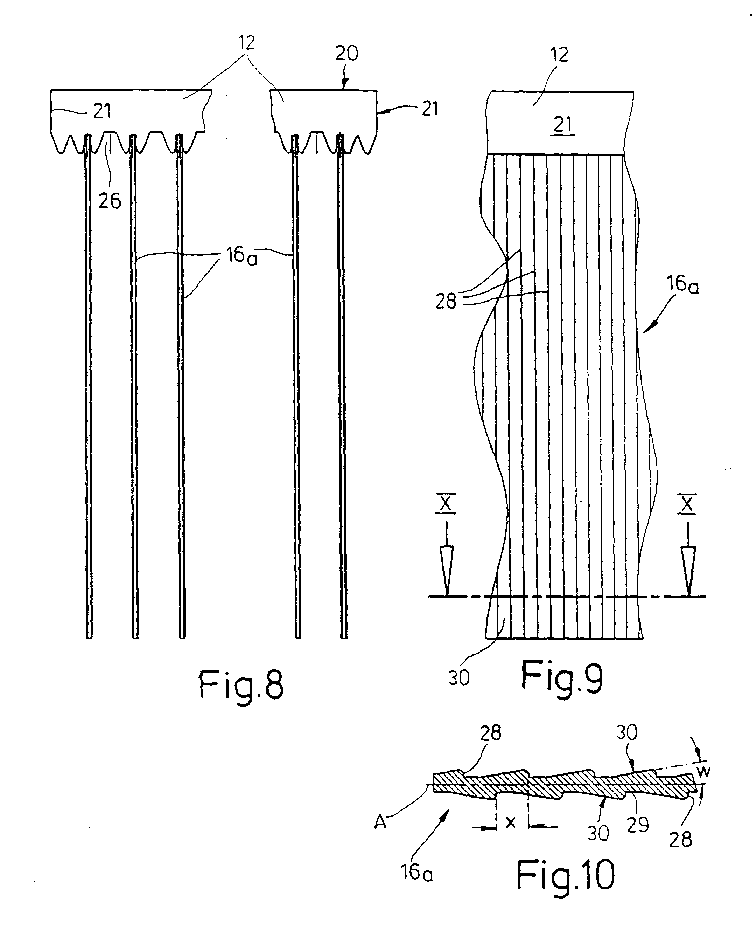

Dies Ausführungsbeispiel der Fig. 8 bis 10 zeigt als Kühlplatte 16ₐ ein längsschnittlich sägezahnartig profiliertes Blech mit an seinen beiden Außenflächen quer zur Längsachse A verlaufenden Schulterabsätzen 28, von denen jeweils ein zur Längsachse A paralleles Flächenstück 29 ausgeht, an das eine in einem spitzen Winkel w zur Längsachse A geneigte Pultfläche 30 anschließt. Die Schulterabsätze 28 sind in Längsrichtung -- im Längsschnitt aufeinander folgend -- um ein Maß x versetzt.

## Patentansprüche

1. Kühlkörper für Halbleiterbauelemente od.dgl. Geräte mit in Abstand zueinander an ein Grundprofil (12) aus stranggepreßtem Aluminium oder anderem Leichtmetall angeschlossenen und davon abragenden Kühlrippen, die profiliert sind und jeweils in einer Einsatznut (14) od.dgl. Ausnehmung des Grundprofils festliegen,
wobei die Kühlrippen jeweils als Kühlplatte (16, 16a) aus einem dünnen Werkstoffstreifen ausgebildet und zumindest im Bereich ihrer Verbindung mit dem Grundprofil (12) durch Profilierung erweitert sind, und entweder
die Kühlplatte (16) aus einem Blech wellenartig ausgeformt ist sowie der die Längsachse (A) querende Abstand zwischen zwei von den Wellenspitzen (19) bestimmten Ebenen (E) der Breite (i) der Einsatznuten (14) entspricht, oder
der Längsschnitt der Kühlplatte (16a) unter Bildung schulterartiger Absätze (28) sägezahnartig profiliert ist sowie der die Längsachse (A) querende Abstand zwischen zwei von den Spitzen der schulterartigen Absätze (28) bestimmten Ebene (E) der Breite (i) der Einsatznuten (14) entspricht.

2. Kühlkörper nach Anspruch 1 **dadurch gekennzeichnet, daß** zwischen zwei benachbarten schulterartigen Absätzen (28) eine längsschnittliche Pultfläche (30) verläuft, die an der Spitze des einen Absatzes endet.

3. Kühlkörper nach Anspruch 2, **dadurch gekennzeichnet, daß** die andere Seite der Pultfläche (30) in ein achsparalleles Flächenstück (29) übergeht.

4. Kühlkörper nach einem der Ansprüche 1 bis 3, **dadurch gekennzeichnet, daß** das Grundprofil (12) zwischen zwei benachbarten Einsatznuten (14) jeweils eine Quereinformung aufweist.

5. Kühlkörper nach Anspruch 4, **dadurch gekennzeichnet, daß** sich der Querschnitt der Quereinformung (26) einwärts verjüngt.

6. Kühlkörper nach Anspruch 4 oder 5, **dadurch gekennzeichnet, daß** das Tiefste der Einsatznut (14). und das Tiefste der Quereinformung (26) einen Abstand (t) bestimmen.

## Claims

1. Heat sink for semiconductor devices or the like comprising cooling fins connected at a distance from one another to a base section (12) made from extruded aluminium or another light metal and projecting therefrom, shaped and each fixed in an insertion slot (14) or similar recess in the base section, the cooling fins each being in the form of a cooling plate (16, 16a) consisting of a thin material strip and being expanded by shaping at least in the region where they are connected to the base section (12), and either the cooling plate (16) being made from a corrugated sheet and the distance between two planes (E) defined by the corrugation peaks (19) traversing the longitudinal axis (A) corresponding to the width (i) of the insertion slots (14), or the longitudinal section of the cooling plate (16a) being shaped in a saw-tooth manner, with the formation of shoulder-like steps (28), and the distance between two planes (E) defined by the peaks of the shoulder-like steps (28) traversing the longitudinal axis (A) corresponding to the width (i) of the insertion slots (14).

2. Heat sink according to claim 1, **characterised in that** a sloping surface (30) extends between two adjacent shoulder-like steps (28) as viewed in longitudinal section and ends at the peak of one step.

3. Heat sink according to claim 2, **characterised in that** the other side of the sloping surface (30) passes over into an axially parallel flat piece (29).

4. Heat sink according to one of claims 1 to 3, **characterised in that** the base section (12) has a respective transverse recess between every two adjacent insertion slots (14).

5. Heat sink according to claim 4, **characterised in that** the cross section of the transverse recess (26) tapers inwards.

6. Heat sink according to claim 4 or claim 5, **characterised in that** the bottom of the insertion slot (14) and the bottom of the transverse recess (26) define a distance (t).

## Revendications

1. Dissipateur de chaleur pour dispositifs semi-conducteurs ou dispositifs similaires comportant des ailettes de refroidissement écartées l'une de l'autre raccordées à un profilé de base (12) en aluminium extrudé ou un autre métal léger et dépassant de celui-ci, qui sont profilées et fixées respectivement dans une rainure de logement (14) ou renfoncement similaire du profil de base, les ailettes de refroidissement étant formées respectivement dans une languette mince de matériau sous forme de plaques de refroidissement (16, 16a) et étant au moins dans la zone de leur liaison avec le profilé de base (12) élargies par profilage, et soit la plaque de refroidissement (16) est formée dans une tôle ondulée, la distance perpendiculaire à l'axe longitudinal (A) entre deux plans (E) définis par les sommets d'ondes (19) correspondant de même à la largeur (i) de ces rainures de logement (14), soit la plaque de refroidissement (16a) est profilée en coupe longitudinale en dents de scie avec formation de talons en forme d'épaulements (28), la distance perpendiculaire à l'axe longitudinal (A) entre deux plans (E) définis par les sommets des talons en forme d'épaulements (28) correspondant de même à la largeur (i) de ces rainures de logement (14).

2. Dissipateur de chaleur suivant la revendication 1, **caractérisé en ce qu'**une surface en pente longitudinale (30) s'étend entre deux talons adjacents en forme d'épaulements (28) et se termine au sommet d'un talon.

3. Dissipateur de chaleur suivant la revendication 2, **caractérisé en ce que** l'autre côté de la surface en pente (30) évolue vers une partie de surface (29) parallèle à l'axe.

4. Dissipateur de chaleur suivant l'une des revendications 1 à 3, **caractérisé en ce que** le profilé de base (12) présente respectivement un moulage transversal entre deux rainures de logement adjacentes (14).

5. Dissipateur de chaleur suivant la revendication 4, **caractérisé en ce que** la section du moulage transversal (26) se rétrécit vers l'intérieur.

6. Dissipateur de chaleur suivant la revendication 4 ou 5, **caractérisé en ce que** la partie la plus profonde de la rainure de logement (14) et la partie la plus profonde du moulage transversal (26) définissent une distance (t).
